# FASCICULE DE BREVET EUROPEEN

(11) **EP 1 299 905 B1**
(45) Date de publication et mention de la délivrance du brevet: **16.04.2008**
(21) Numéro de dépôt: 01954078.0
(22) Date de dépôt: 11.07.2001
(51) Int. Cl.: H01L 21/762, H01L 21/20

(54) **PROCEDE DE DECOUPAGE D'UN BLOC DE MATERIAU ET DE FORMATION D'UN FILM MINCE**
VERFAHREN ZUR TRENNUNG EINER MATERIALBLOCKS UND BILDUNG EINES DÜNNEN FILMS
METHOD FOR CUTTING A BLOCK OF MATERIAL AND FOR FORMING A THIN FILM

(30) Priorité: 12.07.2000 FR 0009129
(43) Date de publication de la demande: 09.04.2003
(73) Titulaire: COMMISSARIAT A L'ENERGIE ATOMIQUE, 75015 Paris (FR)
(72) Inventeur: ASPAR, Bernard, F-38140 Rives (FR); LAGACHE, Chrystelle, 38380 St Laurent du Pont (FR)
(74) Mandataire: Quantin, Bruno Marie Henri
(86) Numéro de dépôt international: PCT/FR2001/002239
(87) Numéro de publication internationale: WO 2002/005344

(56) Documents cités:
- EP-A- 0 793 263
- EP-A- 0 938 129
- WO-A-00/63965
- US-A- 5 811 348
- US-A- 5 909 627
- US-A- 5 994 207
- AGARWAL A ET AL: "EFFICIENT PRODUCTION OF SILICON-ON-INSULATOR FILMS BY CO- IMPLANTATION OF HE+ WITH H+" APPLIED PHYSICS LETTERS, AMERICAN INSTITUTE OF PHYSICS. NEW YORK, US, vol. 72, no. 9, 2 mars 1998 (1998-03-02), pages 1086-1088, XP000742819 ISSN: 0003-6951

## Description

### Domaine technique

La présente invention concerne de façon générale un procédé de découpage d'un bloc de matériau. Ce procédé peut être mis en oeuvre en particulier pour la formation de films minces.

Les films minces, autoportés ou solidaires d'un substrat de support, sont largement utilisés dans les domaines de la micro-électronique, de l'optoélectronique et de la micromécanique. Ainsi, l'invention trouve des applications dans ces domaines, notamment pour la réalisation de composants ou de circuits intégrés.

### Etat de la technique antérieure

Comme évoqué ci-dessus, l'utilisation de couches minces est de plus en plus répandue pour des composants dont le fonctionnement ou le procédé de fabrication font appel à des propriétés physiques et électriques particulières.

Les couches minces présentent une épaisseur qui est habituellement comprise entre quelques nanomètres et quelques micromètres Elles permettent ainsi, par exemple, de mettre en oeuvre des matériaux dont l'usage sous forme de substrat épais serait rédhibitoire pour des raisons de coût ou de compatibilité avec d'autres matériaux utilisés.

La compatibilité des matériaux peut aussi constituer un obstacle à la formation directe d'une couche mince sur un substrat de support sur lequel elle est finalement utilisée. Un certain nombre de procédés ont été développés pour former initialement une couche mince sur un substrat source et pour transférer ensuite la couche mince du substrat source vers un substrat cible.

Ces procédés ainsi que d'autres techniques connues relatives à la fabrication et au transfert de couches minces sont illustrés par les documents (1), (2), (3), (4), (5), (6) et (7) dont les références complètes sont données à la fin de la présente description.

En particulier, le document (1) illustre la possibilité de former par implantation ionique une zone fragilisée dans une plaque de matériau pour ensuite détacher une couche mince superficielle de la plaque au niveau de cette zone.

La séparation de la couche mince du substrat source est provoquée, ou tout au moins assistée, par l'exercice d'un certain nombre de contraintes mécaniques ou thermiques. En particulier le découpage de la couche mince requiert un budget énergétique sous forme thermique et/ou mécanique, qui est lié notamment à la dose des espèces implantées pour former la zone fragilisée.

La mise en oeuvre des techniques de découpage et de transfert d'une couche mince, telle que décrite dans les documents mentionnés ci-dessus, peut être liée à un certain nombre de difficultés. Par exemple, l'usage de certains matériaux à fort coefficient de dilatation thermique n'est pas compatible avec un traitement thermique à trop forte température. Pour certains substrats il est également nécessaire de limiter la dose des espèces implantées soit pour préserver la couche mince soit pour des raisons économiques.

En outre, la mise en oeuvre de forces mécaniques pour séparer le substrat source de la couche mince, telle qu'évoquée ci-dessus en référence au document (7), permet également de réduire le budget thermique de fracture, notamment dans le cas où les matériaux en contact présentent des coefficients de dilatation différents. L'exercice d'efforts mécaniques sur le substrat source et/ou le support cible n'est toutefois pas toujours possible, notamment lorsque les matériaux mis en oeuvre sont fragiles, ou lorsque la zone de clivage n'est pas assez fragilisée par l'implantation ionique.

Finalement, les techniques de séparation et de transfert de couche mince, décrites ci-dessus, impliquent un certain nombre de contraintes et de compromis. Ces contraintes sont imposées en particulier par le type de matériaux utilisés pour constituer le substrat source, la couche mince et le support cible.

### Exposé de l'invention

L'invention a pour but de proposer un procédé de découpage, permettant, en particulier, de former et de transférer des couches minces, qui ne présente pas les limitations évoquées ci-dessus.

Un autre but est de proposer un procédé de découpage pouvant être mis en oeuvre avec un budget énergétique réduit, et en particulier avec un budget thermique réduit.

Un but est encore de proposer un procédé économique dans lequel une éventuelle implantation d'impuretés, destinée à former une zone fragilisée, peut être effectuée avec une dose réduite.

Pour atteindre ces buts l'invention a plus précisément pour objet un procédé de découpage d'un bloc de matériau, comprenant les étapes suivantes :
a) la formation dans le bloc d'une zone enterrée, fragilisée par au moins une étape d'introduction d'ions, la zone enterrée étant formée d'une couche de cavités délimitant au moins une partie superficielle du bloc,
b) la formation au niveau de la zone fragilisée d'au moins une amorce de séparation par l'utilisation d'un premier moyen de séparation choisi parmi l'insertion d'un outil, l'injection locale d'un fluide, un traitement thermique local et/ou une implantation locale d'ions par bombardement d'une espèce ionique différente de celle introduite lors de l'étape précédente, et
c) la séparation au niveau de la zone fragilisée de la partie superficielle du bloc d'une partie restante, dite partie massive, à partir de l'amorce de séparation par l'utilisation d'un deuxième moyen, différent du premier moyen de séparation et choisi parmi un traitement thermique et/ou l'application de forces mécaniques s'exerçant entre la partie superficielle et la zone fragilisée.

La ou les amorces de séparation peuvent être situées sur tout ou partie de la périphérie du bloc et/ou sur des zones locales internes au bloc, et sont aptes à se propager dans la zone fragilisée.

L'invention repose sur le constat qu'il est possible de réduire notablement l'énergie globale à fournir au bloc (qu'elle soit d'origine thermique et/ou mécanique) pour la mise en oeuvre d'un procédé de découpage, en formant une amorce de séparation avant la séparation proprement dite.

Les contraintes mécaniques éventuellement mises à profit pour la séparation peuvent être des contraintes appliquées depuis l'extérieur du bloc ou des contraintes internes présentes dans le bloc.

Bien que les étapes soient exécutées de préférence de façon successive dans l'ordre indiqué, il est possible, pour certaines applications tout au moins, d'exécuter les étapes a et b de manière concomitante. Par ailleurs, les étapes b et c peuvent également être concomitantes.

Selon une mise en oeuvre particulière du procédé, destinée à la fabrication de couches minces, on peut former une zone fragilisée s'étendant de façon sensiblement parallèle à une face sensiblement plane du bloc, pour définir dans le bloc une partie superficielle sous la forme d'une couche superficielle mince.

On entend par face sensiblement plane, une face dont le plan moyen est plan, mais qui peut comporter des micro-rugosités de surface dont les valeurs de rugosité vont de quelques dixièmes de nanomètres à plusieurs centaines de nanomètres. Les inventeurs ont pu mettre en évidence qu'une implantation à travers une surface présentant une micro-rugosité, par exemple d'une valeur RMS (valeur quadratique moyenne) de 10 nm, ne perturbe pas le mécanisme de fragilisation et la fracture subséquente. Cette constatation est intéressante car cette rugosité est de l'ordre de grandeur de la rugosité de la face libre du film après transfert. Il est donc possible dans ces conditions de recycler plusieurs fois le même substrat sans recourir à un polissage de surface.

La zone enterrée fragilisée peut être formée avantageusement par implantation.

Il s'agit, par exemple, d'une implantation d'espèces gazeuses qui permet de former dans le bloc de matériau une fine couche de microcavités. Cette couche délimite la partie superficielle à découper et fragilise localement le bloc de matériau.

On entend par espèces gazeuses des éléments, tels que l'hydrogène ou les gaz rares, par exemple, sous leur forme atomique (par exemple H), sous leur forme moléculaire (par exemple H₂), sous leur forme ionique (par exemple H⁺,H₂⁺), sous leur forme isotopique (par exemple deutérium) ou sous leur forme isotopique et ionique.

Par ailleurs, on entend par implantation toute technique d'introduction dans le bloc des espèces mentionnées ci-dessus, telles que le bombardement la diffusion etc.. Ces techniques peuvent être mises en oeuvre individuellement ou en combinaison de plusieurs d'entre elles.

A titre d'illustration des techniques d'implantation, on peut se reporter aux documents cités précédemment. Toutefois grâce à la formation d'une amorce de séparation, conformément à l'invention, les doses des espèces implantées pour former la zone fragilisée peuvent être réduites. Les doses réduites permettent de moins perturber l'état de surface des couches minces, ou des parties découpées, et ainsi d'en contrôler la rugosité.

Selon un aspect particulier de l'invention on peut effectuer localement une implantation avec un surdosage pour former l'amorce de séparation, le premier moyen de séparation correspond alors à un surdosage.

Cette possibilité est très intéressante dans la mesure ou une implantation à forte dose n'a lieu que dans une partie réduite du bloc de matériau. De plus, comme indiqué précédemment, une dose beaucoup plus faible peut être utilisée pour former la zone fragilisée.

L'amorce de séparation peut être formée dans un même plan que la zone fragilisée comme une prolongation de cette zone. Si l'initiation de l'amorce est réalisée dans un autre plan que celui de la zone fragilisée, la propagation de l'amorce rejoint la zone fragilisée.

Plusieurs possibilités peuvent être retenues pour la formation de l'amorce de séparation.

Selon une première possibilité, l'amorce de séparation peut être formée par une implantation ionique d'une espèce différente de celle retenue pour la formation de la zone fragilisée.

Selon une autre possibilité, on peut former l'amorce de séparation par l'insertion dans le bloc d'un outil. Le premier moyen de séparation correspond alors à l'insertion de l'outil.

Selon encore une autre possibilité, on peut former l'amorce de séparation par injection locale d'un fluide sur le bloc. Le premier moyen de séparation correspond alors à l'injection de fluide.

Selon encore une autre possibilité on peut former l'amorce de séparation par un traitement thermique local du bloc. Le premier moyen de séparation correspond alors au traitement thermique local.

Dans une application du procédé de l'invention à la formation d'une couche mince, en fonction de son épaisseur, il est peut-être avantageux de la rendre solidaire d'un raidisseur avant l'étape c de séparation (voire même avant d'étape b). Le raidisseur peut être déposé à la surface du bloc de matériau, en contact avec la couche mince à découper, selon une quelconque technique de dépôt. Il peut aussi être rendu solidaire de la couche mince par adhésion moléculaire ou par collage au moyen d'un liant (colle).

Lorsqu'en revanche la couche mince ou la partie à découper est suffisamment épaisse ou est en un matériau suffisamment rigide pour ne pas se déchirer, la présence d'un raidisseur n'est pas indispensable. Dans la suite du texte, on désigne une partie ou une couche présentant une épaisseur ou une rigidité suffisantes pour ne pas se déchirer lors de la séparation, par partie ou couche "autoportée".

D'autres caractéristiques et avantages de l'invention ressortiront de la description qui va suivre, en référence aux figures des dessins annexés. Cette description est donnée à titre purement illustratif et non limitatif.

### Brève description des figures

- Les figures 1A à 1D sont des coupes schématiques d'un substrat et illustrent des étapes de découpage d'une couche mince, maintenue par un raidisseur, selon un procédé conforme à l'invention.
- Les figures 2A à 2C sont des coupes schématiques d'un substrat et illustrent des étapes découpage d'une couche mince autoportée, selon un procédé conforme à l'invention.
- Les figures 3A à 3D sont des coupes schématiques d'un substrat et illustrent des étapes de découpage d'une couche mince, maintenue par un raidisseur, selon un procédé conforme à l'invention et constituant une variante par rapport au procédé illustré par les figures 1A à 1D.

### Description détaillée de modes de mise en oeuvre de l'invention

Dans la description qui suit, des parties identiques, similaires ou équivalentes des différentes figures sont repérées par les mêmes références, de façon à pouvoir se reporter plus facilement d'un mode de réalisation à l'autre.

Il convient, par ailleurs, dé préciser que les différentes figures et les différentes parties des figures ne sont pas représentées selon une échelle homogène pour augmenter la lisibilité des figures.

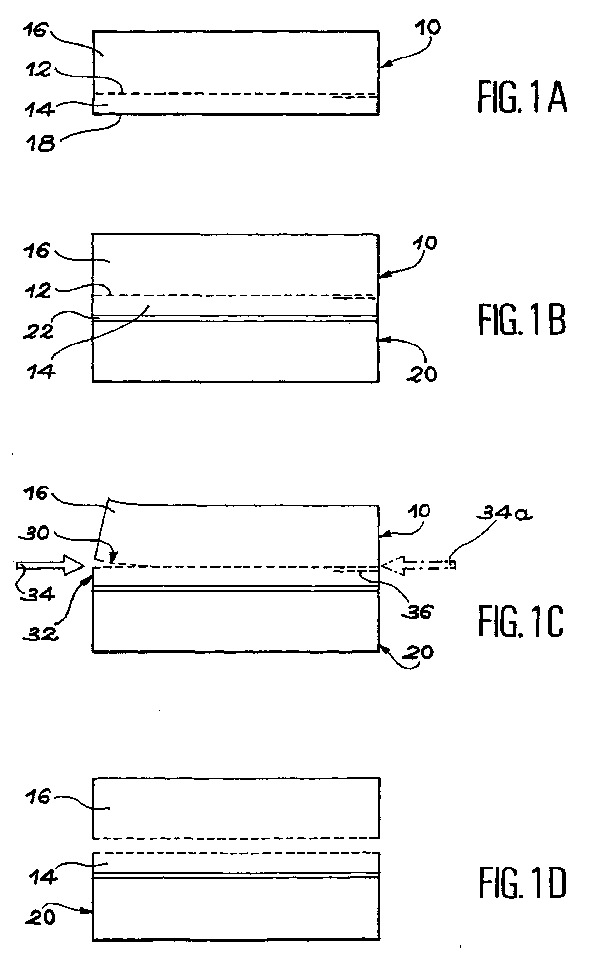

La figure 1A montre un substrat 10 qui constitue un bloc de matériau, homogène ou non, tel qu'évoqué dans la description qui précède. Ce bloc peut être, par exemple, un lingot ou une plaquette de matériau semi-conducteur ou piézo-électrique ou encore ferroélectrique. Il peut être préalablement traité ou non. Dans le cas où le bloc est une plaquette de semi-conducteur traitée ou non, il s'agit par exemple d'un substrat de silicium.

Une implantation ionique d'hydrogène avec une dose de l'ordre de 7.10¹⁶ H⁺/cm² à une énergie de 100keV, par exemple, permet de former dans le substrat une zone fragilisée 12. Celle-ci s'étend sensiblement selon un plan parallèle à la surface du substrat par laquelle les impuretés ont été implantées. Dans l'exemple de la figure les impuretés sont implantées par une face du substrat 18 qui est désignée dans la suite du texte par face superficielle. La zone fragilisée délimite dans le substrat 10 une couche mince superficielle 14 et une partie massive 16. Selon les conditions d'implantation, il peut être intéressant de réaliser un traitement thermique pour augmenter la fragilisation. On peut procéder, par exemple, à un traitement thermique de deux heures à 350°C.

La figure 1B, montre le report de la face superficielle de la couche mince 14 sur un deuxième substrat 20 appelé substrat cible et qui peut constituer un raidisseur pour la couche mince. Il s'agit, par exemple, d'un substrat de silice fondu appelé abusivement quartz.

La solidarisation de la couche 14 avec le substrat 20 peut être réalisée soit directement par adhésion moléculaire, soit comme représenté sur les figures 1 par l'intermédiaire d'au moins une couche de matériau 22 disposée sur la couche mince et/ou sur le substrat. Dans ce dernier cas, la couche intermédiaire 22 est choisie soit pour favoriser l'adhésion moléculaire (par exemple du SiO₂ soit pour réaliser un collage adhésif (par exemple une couche de colle).

Dans le cas d'un collage moléculaire direct entre les faces à assembler des deux substrats, les substrats subissent, par exemple, un traitement de nettoyage chimique destiné à rendre hydrophiles les faces à assembler. Après la mise en contact des faces à assembler, les substrats peuvent subir éventuellement un premier traitement thermique destiné en particulier à renforcer les forces d'adhésion et/ou à augmenter la fragilisation au niveau de la zone implantée. Ce traitement est effectué, par exemple, avec un budget thermique de l'ordre de 300°C pendant 2 heures.

La figure 1C, montre la formation d'une amorce de séparation 30 dans le substrat 10. L'amorce de séparation 30 s'étend depuis une face extérieure 32 du substrat 10, en l'occurrence une face latérale sur la figure, jusqu'à la zone fragilisée 12. L'amorce de séparation peut être provoquée par différents moyens, représentés symboliquement sur la figure sous la forme d'une flèche avec la référence 34. Ces moyens peuvent comporter une injection d'eau, ou d'un autre fluide, ou un outil, tel qu'une lame, insérés au niveau de la zone fragilisée.

Selon une autre possibilité, l'amorce de séparation peut être provoquée par une implantation ionique avec un surdosage limité à une région de bordure du substrat. Une telle région est représentée sur les figures avec la référence 36.

Bien entendu, le surdosage peut être réalisé dans d'autres régions du substrat telles que, par exemple, une région centrale.

Dans ce cas, la formation de l'amorce de séparation peut avoir lieu éventuellement lors d'une même étape d'implantation mise en oeuvre également pour la formation de la zone fragilisée. Pour se rapporter à l'exemple numérique donné précédemment, la région 36 est surimplantée, par exemple avec une dose de 9.10¹⁶H⁺/cm²_{.}

Selon encore une autre possibilité, une amorce de séparation peut être provoquée en surchauffant localement le substrat (par exemple à l'aide d'un laser ou d'une source chaude locale).

Il convient de remarquer ici que les termes "amorce de séparation" désignent dans le cadre du présent exposé soit une région dans laquelle la séparation est déjà entamée, soit une région, particulièrement fragile, dans laquelle la séparation sera entamée lors d'une étape ultérieure de séparation proprement dite.

Une flèche 34a en trait mixte indique la possibilité de former une seule ou une pluralité d'amorces de séparation.

La figure 1D montre une étape finale de séparation de la couche mince 14 et de la partie massive 16 du substrat. La séparation peut être assistée par l'exercice de contraintes mécaniques, sous forme de pression, de forces de traction de cisaillement ou de pelage, et/ou par un traitement thermique. A titre d'exemple, dans les conditions évoquées précédemment, on peut effectuer un traitement thermique de quelques minutes à 350°C pour obtenir la séparation totale. Le budget thermique mis en oeuvre pour obtenir la séparation des parties tient compte des traitements thermiques préalables, tel que, par exemple, un traitement thermique pour renforcer l'adhérence entre les substrats, ont été effectués. Dans tous les cas, ce budget thermique est réduit du fait de l'utilisation de l'amorce de séparation.

On obtient finalement une structure formée du substrat cible 20 à la surface duquel se trouve la couche mince 14.

La partie massive 16 du premier substrat peut être réutilisée pour le découpage ultérieur d'une autre couche mince. Elle peut éventuellement servir aussi comme substrat cible pour le support d'une autre couche mince d'un autre matériau.

Grâce au procédé illustré par les figures 1A à 1D, il est possible, par exemple, d'obtenir également des structures comportant sur un substrat de silicium des matériaux non semi-conducteurs tels que le LiNbO₃, le LiTaO₃ ou le SrTiO₃, par exemple. On peut aussi reporter des couches de matériaux semi-conducteurs III-V sur du silicium ou sur d'autres semi-conducteurs III-V. Le procédé peut également être mis en oeuvre pour obtenir des substrats de type SOI (silicium sur isolant).

On donne ci-après, à titre d'illustration des paramètres de procédé pouvant être retenus pour la fabrication d'un support SOI.

Lors de la première étape on effectue une implantation ionique d'hydrogène avec une dose de 7.10¹⁶H⁺/cm² à 100KeV dans une plaque standard de silicium oxydée en surface. Cette implantation permet de définir une couche mince délimitée par une zone fragilisée. Un surdosage local à 9.10¹⁶H⁺/cm² est effectuée à la périphérie de la zone fragilisée. Le surdosage permet de former une amorce de séparation au sens de l'invention sur une longueur de 1 à 2 cm, depuis le bord de la plaque dans le cas d'une amorce en bordure de plaque. Après le report de la plaque sur une autre plaque de silicium sur laquelle on fait adhérer la couche d'oxyde, on procède à un traitement thermique de séparation. On observe qu'un traitement de 4 heures à 350°C permet d'obtenir une séparation qui se propage à partir de l'amorce sur l'ensemble de la zone fragilisée.

En l'absence de l'amorce de séparation, il serait également possible de provoquer la séparation. Toutefois dans ce cas, un traitement thermique de 350°C pendant 11 heures serait nécessaire. Ceci montre la réduction importante du budget thermique imposé aux substrats, grâce à l'invention.

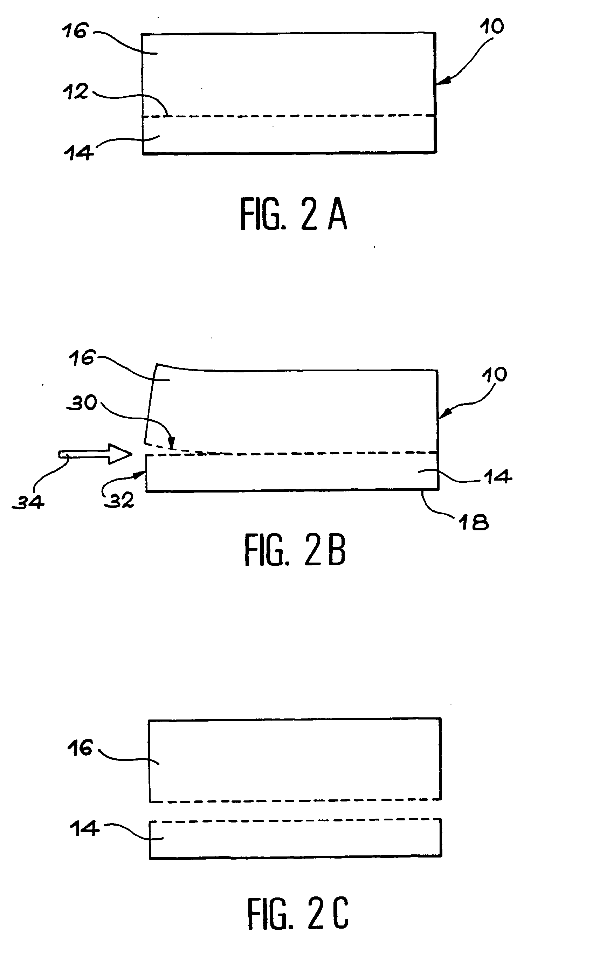

La figure 2A, qui illustre la première étape d'une deuxième possibilité de mise en oeuvre de l'invention, est identique à la figure 1A. On peut donc se reporter à la description qui précède au sujet de cette figure.

La figure 2B illustre la formation d'une amorce de séparation 30. On observe que l'amorce 30 est pratiquée sensiblement au niveau de la zone fragilisée 12 et que, par ailleurs, la surface 18 de la couche mince 14 est laissée libre.

La figure 2C montre l'étape finale de séparation qui est provoquée sans équiper la couche mince 14 d'un raidisseur. Une telle mise en oeuvre du procédé est adaptée en particulier à la formation de couches minces autoportées.

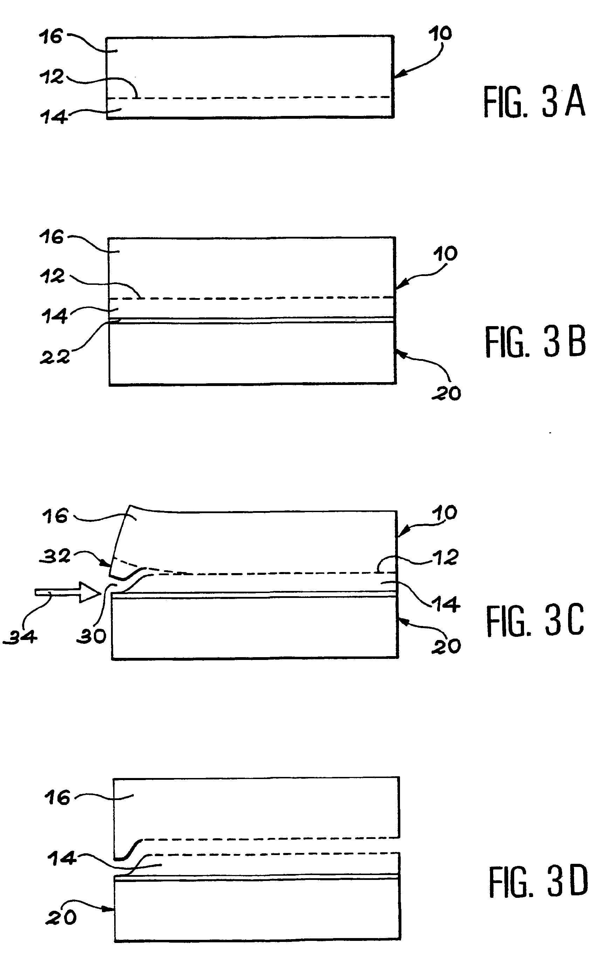

Les figures 3A à 3D montrent encore une autre possibilité de mise en oeuvre du procédé. Les figures 3A et 3B sont identiques aux figures 1A et 1B, de sorte que leur description n'est pas répétée.

La figure 3C, qui illustre la formation d'une amorce de séparation, montre que les moyens de séparation 34 peuvent être appliqués ailleurs qu'au niveau de la zone fragilisée 12. Dans l'exemple de la figure 3C, un outil, tel qu'une lame est inséré sur un coté latéral 32 de la structure, au niveau de l'interface entre le premier substrat 10 et le substrat cible 20. L'outil est inséré par exemple au niveau de la couche intermédiaire 22 lorsqu'elle existe. En raison de l'épaisseur relativement fine de la couche mince, par exemple inférieure ou de l'ordre de quelques µm, c'est-à-dire de la faible profondeur de la zone fragilisée dans le premier substrat 20, l'amorce de séparation se propage à travers la couche mince pour venir rejoindre la zone fragilisée 12.

La figure 3D illustre la séparation finale qui se propage depuis l'amorce 30 sur l'ensemble de la surface de la couche mince en suivant la zone fragilisée.

Comme évoqué précédemment, la présence d'une amorce de séparation permet de réduire le budget thermique de la dernière étape et/ou permet de réduire la dose d'implantation de la zone fragilisée. En jouant sur ces deux paramètres, il est ainsi possible de contrôler la rugosité de la partie massive 16 et surtout de la couche mince 14.

Une application particulière de l'invention est le découpage d'un bloc de matériau tel que tout ou partie d'une plaque qui a subi ou non d'autres traitements tels que la fabrication de composants.

En particulier, l'invention peut être mise à profit pour le transfert de puces (chips, dies, sensors, optoelectronic devices, etc...)

### DOCUMENTS CITES

(1) FR-A-2681472 / US-A-5374564
(2) FR-A-2773261
(3) FR-A-2748851
(4) FR-A-9909007
(5) US-A-5994207
(6) EP-A-0925888
(7) FR-A-2 748 851
(8) EP-A-0 793 263

## Revendications

1. Procédé de découpage d'un bloc de matériau (10) comprenant les étapes suivantes :
a) la formation dans le bloc d'une zone enterrée (12), fragilisée par au moins une étape d'introduction d'ions, la zone enterrée étant formée d'une couche de micro-cavités délimitant au moins une partie superficielle (14) du bloc,
b) la formation au niveau de la zone fragilisée d'au moins une amorce de séparation (30, 36) par l'utilisation d'un premier moyen de séparation (34, 34a) choisi parmi l'insertion d'un outil, l'injection locale d'un fluide, un traitement thermique local et/ou une implantation locale d'ions par bombardement d'une espèce ionique différente de celle introduite lors de l'étape précédente, et
c) la séparation au niveau de la zone fragilisée de la partie superficielle (14) du bloc d'une partie restante (16), dite partie massive, à partir de l'amorce de séparation par l'utilisation d'un deuxième moyen, différent du premier moyen de séparation et choisi parmi un traitement thermique et/ou l'application de forces mécaniques s'exerçant entre la partie superficielle et la zone fragilisée.

2. Procédé selon la revendication 1, dans lequel l'amorce de séparation est formée sur tout ou partie de la périphérie du bloc.

3. Procédé selon la revendication 1, dans lequel l'amorce de séparation est formée sur des zones locales internes du bloc.

4. Procédé selon l'une quelconque des revendications 1 à 3, dans lequel on forme une zone fragilisée s'étendant de façon sensiblement parallèle à une face sensiblement plane du bloc, pour définir dans le bloc une partie superficielle sous la forme d'une couche superficielle mince.

5. Procédé selon l'une quelconque des revendications 1 à 4, dans lequel les étapes a) et b) sont concomitantes.

6. Procédé selon l'une quelconque des revendications 1 à 4, **caractérisé en ce que** les étapes b) et c) sont concomitantes.

7. Procédé selon l'une quelconque des revendications 1 à 6, dans lequel on effectue localement une implantation avec un surdosage pour former l'amorce de séparation (36).

8. Procédé selon l'une quelconque des revendications 1 à 7, dans lequel lors de l'étape c) on applique des forces mécaniques sous la forme de forces exercées depuis l'extérieur du bloc, et/ou de contraintes internes présentes dans le bloc.

9. Procédé selon la revendication 4, dans lequel, avant l'étape c), on met en contact la couche mince superficielle avec un raidisseur.

10. Procédé selon la revendication 9, dans lequel on dépose sur la couche mince superficielle au moins une couche de matériau formant ledit raidisseur.

11. Procédé selon la revendication 9, dans lequel on rend solidaire la couche mince superficielle d'un raidisseur par collage ou par adhésion moléculaire de contact.

12. Procédé selon l'une quelconque des revendications 1 à 11, dans lequel, après l'étape c), on réutilise la partie massive (16) du bloc de matériau, pour le découpage d'une nouvelle partie superficielle.

13. Procédé selon l'une quelconque des revendications 1 à 11, dans lequel, après l'étape c), on réutilise la partie massive du bloc de matériau (16), comme raidisseur pour la partie superficielle d'un autre bloc.

14. Procédé selon l'une quelconque des revendications 1 à 13, dans lequel, entre les étapes a) et b), on procède à un traitement thermique pour augmenter la fragilisation de la zone enterrée.

## Claims

1. Process for cutting out a block (10) of material, comprising the following steps:
a) the formation in the block of a buried zone (12), embrittled by at least one ion introduction step, the buried zone being formed of a layer of microcavities delimiting at least one superficial portion (14) of the block,
b) the formation at the level of the embrittled zone of at least one separation initiator (30, 36) using first separation means (34, 34a) chosen from insertion of a tool, local injection of a fluid, local thermal treatment and/or local implantation of ions by bombardment with an ionic species different from that introduced during the preceding step, and
c) the separation at the level of the embrittled zone of the superficial portion (14) of the block from a remaining portion (16), referred to as the mass portion, starting from the separation initiator, using second means, different from the first separation means and chosen from thermal treatment and/or the application of mechanical forces operative between the superficial portion and the embrittled zone.

2. Process according to claim 1, wherein the separation initiator is formed over all or part of the periphery of the block.

3. Process according to claim 1, wherein the separation initiator is formed in internal local zones of the block.

4. Process according to any one of claims 1 to 3, wherein a embrittled zone is formed extending substantially parallel to a substantially plane face of the block, to define in the block a superficial portion in the form of a thin superficial layer.

5. Process according to any one of claims 1 to 4, wherein the steps a) and b) are concomitant.

6. Process according to any one of claims 1 to 4, **characterised in that** the steps b) and c) are concomitant.

7. Process according to any one of claims 1 to 6, wherein implantation is effected locally with an overdose to form the separation initiator (36).

8. Process according to any one of claims 1 to 7, wherein during the step c) mechanical forces are applied in the form of forces operative from outside the block and/or internal stresses present in the block.

9. Process according to claim 4, wherein, before the step c), the thin superficial layer is brought into contact with a stiffener.

10. Process according to claim 9, wherein there is deposited on the thin superficial layer at least one layer of material forming said stiffener.

11. Process according to claim 9, wherein the thin superficial layer is fastened to a stiffener by gluing or by contact molecular adhesion.

12. Process according to any one of claims 1 to 11, wherein, after the step c), the mass portion (16) of the block of material is used again to cut a new superficial portion.

13. Process according to any one of claims 1 to 11, wherein, after the step c), the mass portion of the block (16) of material is used again as a stiffener for the superficial portion of another block.

14. Process according to any one of claims 1 to 13, wherein, between the steps a) and b), thermal treatment is carried out to weaken further the buried zone.

## Patentansprüche

1. Verfahren zum Trennen eines Werkstoffblocks (10), umfassend die folgenden Schritte:
a) die Bildung einer versenkten Zone (12) in dem Block, die durch mindestens einen Schritt der Einführung von Ionen versprödet ist, wobei die versenkte Zone von einer Schicht von Mikrohohlräumen gebildet ist, die mindestens einen Oberflächenteil (14) des Blocks bildet,
b) die Bildung mindestens eines Trennungsansatzes (30, 36) auf Höhe der versprödeten Zone durch die Verwendung eines ersten Trennmittels (34, 34a), das aus der Einführung eines Werkzeugs, der örtlichen Einspritzung eines Fluids, einer örtlichen Wärmebehandlung und/oder einer örtlichen Ionenimplantierung durch Beschuss mit einer anderen Ionenspezies als der bei dem vorhergehenden Schritt eingeführten Spezies ausgewählt ist, und
c) die Trennung des Oberflächenteils (14) des Blocks auf Höhe der versprödeten Zone von einem restlichen Teil (16), massiver Teil genannt, ausgehend von dem Trennungsansatz durch die Verwendung eines zweiten Mittels, das von dem ersten Trennmittel verschieden ist und aus einer Wärmebehandlung und/oder dem Anlegen von mechanischen Kräften, die zwischen dem Oberflächenteil und der versprödeten Zone ausgeübt werden, ausgewählt ist.

2. Verfahren nach Anspruch 1, bei dem der Trennungsansatz auf dem ganzen Umfang des Blocks oder einem Teil davon gebildet ist.

3. Verfahren nach Anspruch 1, bei dem der Trennungsansatz auf inneren örtlichen Zonen des Blocks gebildet ist.

4. Verfahren nach einem der Ansprüche 1 bis 3, bei dem man eine versprödete Zone bildet, die sich im Wesentlichen parallel zu einer im Wesentlichen ebenen Zone des Blocks erstreckt, um in dem Block einen Oberflächenteil in der Form einer dünnen Oberflächenschicht zu bilden.

5. Verfahren nach einem der Ansprüche 1 bis 4, bei dem die Schritte a) und b) gleichzeitig stattfinden.

6. Verfahren nach einem der Ansprüche 1 bis 4, **dadurch gekennzeichnet, dass** die Schritte b) und c) gleichzeitig stattfinden.

7. Verfahren nach einem der Ansprüche 1 bis 6, bei dem man örtlich eine Implantierung mit einer Überdosis vornimmt, um den Trennungsansatz (36) zu bilden.

8. Verfahren nach einem der Ansprüche 1 bis 7, bei dem man im Schritt c) mechanische Kräfte in der Form von Kräften anlegt, die von außerhalb des Blocks ausgeübt werden, und/oder von in dem Block vorhandenen inneren Spannungen.

9. Verfahren nach Anspruch 4, bei dem man vor dem Schritt c) die dünne Oberflächenschicht mit einer Versteifung in Kontakt bringt.

10. Verfahren nach Anspruch 9, bei dem man auf die dünne Oberflächenschicht mindestens eine diese Versteifung bildende Werkstoffschicht aufbringt.

11. Verfahren nach Anspruch 9, bei dem man die dünne Oberflächenschicht durch Verkleben oder durch molekulare Kontakthaftung mit einer Versteifung fest verbindet.

12. Verfahren nach einem der Ansprüche 1 bis 11, bei dem man nach dem Schritt c) den massiven Teil (16) des Werkstoffblocks für das Abtrennen eines neuen Oberflächenteils wiederverwendet.

13. Verfahren nach einem der Ansprüche 1 bis 11, bei dem man nach dem Schritt c) den massiven Teil des Werkstoffblocks (16) als Versteifung für den Oberflächenteil eines anderen Blocks wiederverwendet.

14. Verfahren nach einem der Ansprüche 1 bis 13, bei dem man zwischen den Schritten a) und b) eine Wärmebehandlung vornimmt, um die Versprödung der versenkten Zone zu erhöhen.
